Europäisches Patentamt

European Patent Office

Office européen des brevets

(11) Publication number: **0 137 656**
**B1**

# EUROPEAN PATENT SPECIFICATION

(45) Date of publication of patent specification: **29.03.89**

(51) Int. Cl.⁴: **H 05 K 7/10**

(21) Application number: **84305566.6**

(22) Date of filing: **16.08.84**

(54) Electrical connecting device including socket therefor.

(30) Priority: **16.08.83 US 523802**

(43) Date of publication of application:
**17.04.85 Bulletin 85/16**

(45) Publication of the grant of the patent:
**29.03.89 Bulletin 89/13**

(84) Designated Contracting States:
**BE CH DE FR GB IT LI NL SE**

(56) References cited:
**EP-A-0 070 120**
**US-A-4 060 296**
**US-A-4 385 791**
**US-A-4 477 862**

**IEEE SPECTRUM, vol. 9, no. 9, September 1972, page 83, IEEE, New York, US; "Plated plastic dual-in-line sockets eliminate the separate contacts normally used"**

(73) Proprietor: **THOMAS & BETTS CORPORATION**
**920 Route 202**
**Raritan New Jersey 08869 (US)**

(72) Inventor: **Sadigh-Behzadi, Amir-Akbar**
**14960 Lanark Street Van Nuys**
**Los Angeles California 91402 (US)**

(74) Representative: **Howick, Nicholas Keith et al**
**CARPMAELS & RANSFORD 43 Bloomsbury Square**
**London WC1A 2RA (GB)**

Courier Press, Leamington Spa, England.

## Description

Field of the invention:
This invention relates to an electrical connecting device for disengageably connecting an electric package to a printed circuit board or the like and more particularly to a socket for use in such device.

Background of the invention:
The use of electronic components and other electric packages in miniature and microminiature circuitry has become well-known and commercially successful. The interconnection of integrated circuits (ICs) and printed circuit boards (PCBs) is commonly required in such circuitry. One means of interconnection is to directly "hard" connect by soldering the leads of an IC to the conductive traces of a PCB or to metallized apertures provided therein. As flexibility in repair and replacement is minimal in soldering the IC to the PCB, various techniques and connecting devices have been developed wherein carriers or intermediate sockets provide removable connection of the IC to the PCB. In these devices, as shown, for example, in U.S. Patents 3,621,157; 3,993,381; 4,060,296; and 4,072,380, the leads of the IC are typically disengageably connected by pressure to the contacts of a socket or carrier by means of spring bias arrangements or camming structures and the socket or carrier contacts are then in turn soldered to the PCB. As the leads of commercially available ICs are typically provided with leads having tin thereon, a problem in meeting environmental standards is commonly faced. A tin interface, and especially a tin-tin interface, in a pressure contact often results in a fritting or corrosive deterioration. Accordingly, while the current trend is toward the use of intermediate sockets because replacement and service are made easier and faster and also because the relatively soft leads of the IC are protected by the intermediate sockets, further consideration is to be given to the reliability aspects of the IC and PCB interconnections. In addition, as the density of ICs in very large scale integrated circuitry continues to increase, the judicious use of space and size in interconnecting devices must be contemplated.

Summary of the invention:
It is an object of the present invention to provide an improved electrical connecting device in meeting the desired electrical reliability aspects and in overcoming the difficulties of the prior art.
It is a further object of the present invention to provide a socket for receiving and connecting to an integrated circuit and wherein the socket is readily disengageable with conductors on an electric component, such as a PCB or the like.
In accordance with the invention there is provided an electrical socket for disengageable connection to conductors of an electric component comprising:
an elongate insulative housing for receiving an electric package having a plurality of conductive leads extending therefrom, said housing including a central portion having a plurality of apertures extending in spaced disposition longitudinally along the housing central portion, said housing including two lateral portions extending transversely relative to the longitudinal axis of the central portion along said housing, two rows of openings extending longitudinally in each of said lateral portions, said rows of openings being laterally spaced from each other, said lateral portions having a plurality of laterally extending, longitudinally spaced recesses, each recess communicating with one opening of each row; and
a plurality of conductive electrical contacts supported on said housing, each contact including a first end portion disposed in a respective one of said apertures for disengageable electrical engagement with a conductor of said electrical component and a second end portion having a projecting extent, each projecting extent lying in a respective recess in said housing lateral portions, there being on each projecting extent a pair of contact members in registry with a pair of said openings, one from each row, in said lateral portions, said contact members adapted for selective engagement with said leads of said electric package.
According to the invention there is further provided an electrical socket for disengageable connection to conductors of an electric component comprising:
an elongate insulative housing for receiving an electric package having a plurality of leads extending therefrom in two laterally spaced longitudinally extending rows, said housing being adapted to receive electric packages having leads of different lateral spacing;
a first plurality of contacts supported by said housing and extending longitudinally thereon;
a second plurality of contacts supported by said housing laterally spaced from said first plurality of contacts and extending in corresponding longitudinal position with the first plurality of contacts;
each of said contacts of said first and second pluralities having a first end portion for disengageable electrical connection to a conductor of said electric component;
each of said contacts of said first and second pluralities have a second end portion for nondetachable securement with a lead of one of said electric packages, each of said second end portions having at least first and second contact members laterally spaced from each other for selective securement with a lead of said electric package, the first contact members of a spaced corresponding pair of contacts defining a first lateral spacing and the second contact members of such spaced corresponding pair of contacts defining a second lateral spacing different from said first lateral spacing, said first and second lateral spacings providing selectivity for receipt of electric packages having leads of different lateral spacings, the first end portions of a spaced corresponding pair of contacts of said first and second pluralities defining a third lateral spacing that is less than both said first and second lateral spacings,

said housing including a central portion for supporting said contact first end portions and transversely spaced lateral portions for supporting respectively the second end portions of the first and second pluralities of contacts, said housing lateral portions each having an opening in registry with each said contact member for joint receipt therein of a portion of one of said contact members and a lead of said electric package.

In a particularly preferred arrangement, the leads of the electric package extend from the housing and are soldered to the socket contacts, the socket contacts being covered in part by a suitable material such as gold, to facilitate disengageable connection to the conductors of the electric component. In addition, the socket contacts, arranged in two laterally spaced, longitudinally extending rows, are each formed with at least two laterally spaced contact members providing the selectivity in the securement thereto of packages of differently spaced leads.

Brief description of the drawings:

Fig. 1 is a perspective top view of a connector module embodying the present invention and broken away to reveal particular details thereof.

Fig. 2 is a sectional view of the socket assembly of Fig. 1 with one of the electric packages shown in disassembled condition for illustrative purposes.

Figs. 3 and 4 are top and bottom plan views respectively of the socket housing of the present invention.

Fig. 5 is an enlarged, partially fragmented view of the rightward portion of the socket assembly of Fig. 2 to illustrate particular details of the contact members of the socket assembly.

Fig. 6 is a plan view of a preferred arrangement of the socket assembly showing the interconnection of various electric packages in longitudinally spaced positions.

Detailed description of the preferred embodiment:

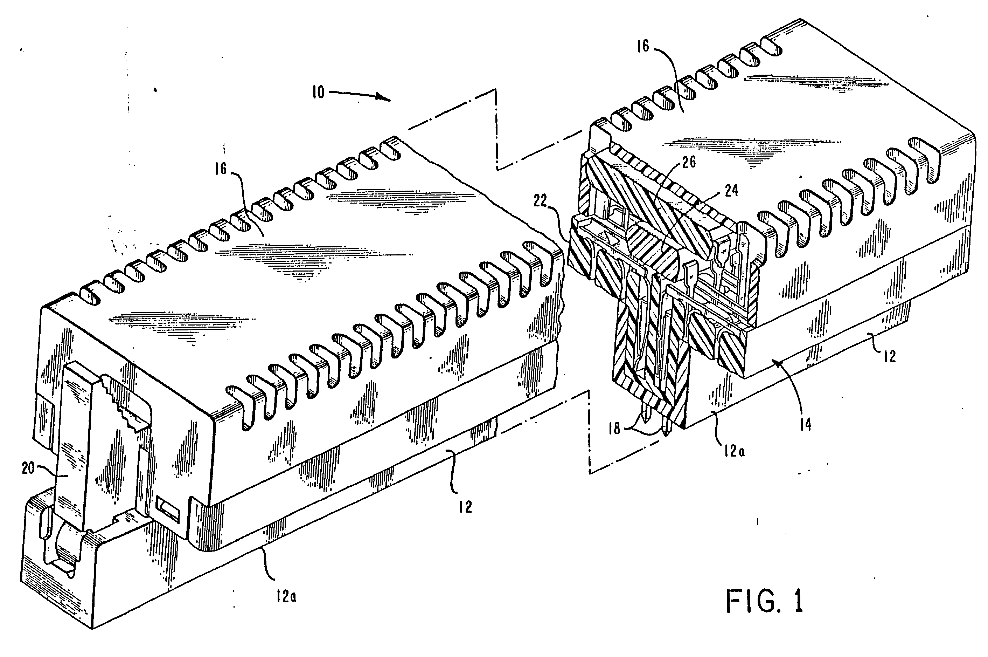

Referring now to the drawing, there is shown in Fig. 1 an electrical connector module 10 embodying the features of the present invention. Connector module 10 comprises a header 12, a socket assembly 14 and an insulative cover 16. The header 12 includes an elongate insulative base 12a supporting a plurality of conductive pins 18 arranged in two laterally spaced, longitudinally extending rows. An ejector mechanism 20 of conventional construction is hingedly attached to the header 12 for ease of ejection of the socket assembly 14. The socket assembly 14 comprises, briefly, a socket 22 and one or more electric packages such as packages 24 and 26. Packages 24 and 26 are integrated circuits (ICs) such as EPROMs and are configured in a manner of a dual-in-line package having two substantially parallel rows of conductive leads projecting from a package housing. While electronic components such as EPROMs are described, it should be understood that electric packages such as resistor networks or capacitive components may also be utilized with the present invention.

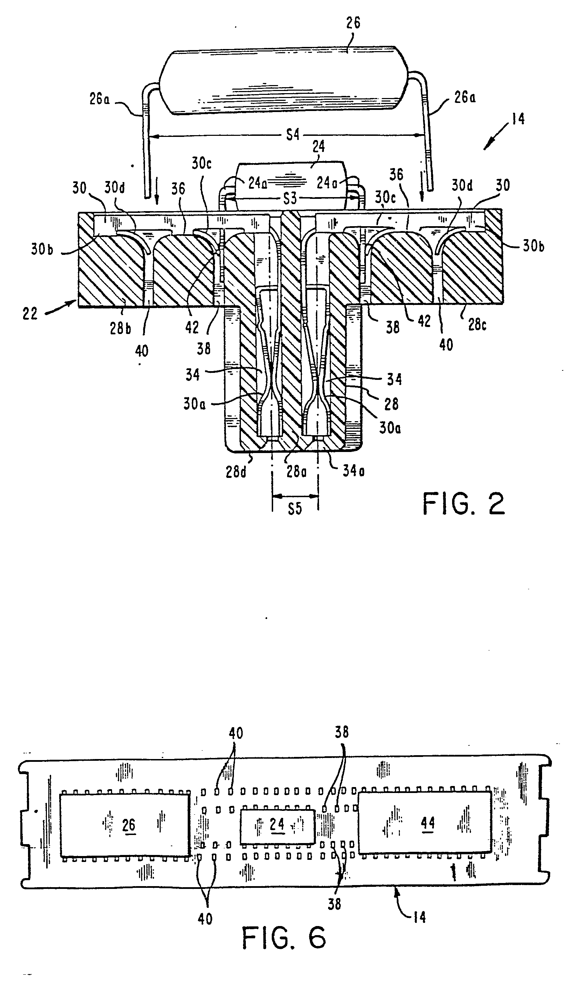

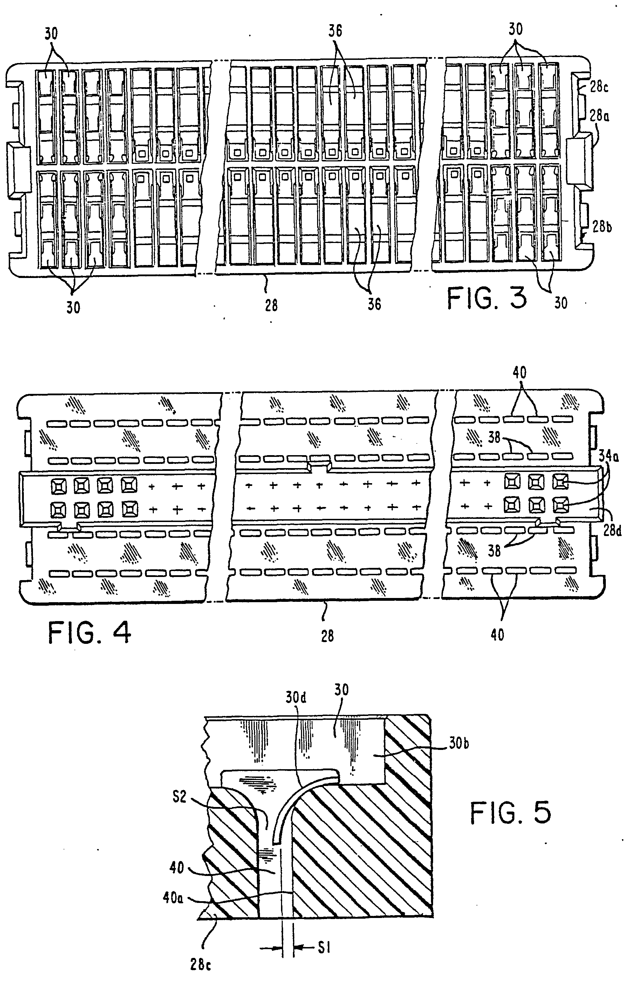

Turning now to Figs. 2—4, the details of the socket 22 are described and illustrated. Socket 22 comprises an elongate insulative body or housing 28 having a central portion 28a and two laterally projecting portions 28b and 28c as depicted in Fig. 2. As illustrated in the view of Fig. 2, the cross-section of the housing 28 is generally T-shaped. A plurality of substantially identical electrically conductive contacts 30 are supported by the housing 28 in separate, insulated manner in two laterally spaced, longitudinally extending rows, as shown in Figs. 2 and 3. In such arrangement, the contacts 30 in each row are in corresponding longitudinal position defining a plurality of pairs of longitudinally extending contacts. Each of the contacts comprises a first end portion 30a and a second end portion 30b, the preferred construction of such contact 30 being integrally formed from a sheet of conductive material, such as a copper-nickel alloy, by a conventional stamping technique. The contacts 30, as so formed in self-sustained construction, are thereafter assembled to the housing 28 to form the socket 22. The first end portions 30a are disposed in apertures 34 that extend through the central portions 28a of the housing 28. The contact end portions 30a, as shown in Fig. 2, comprise a socket-type construction for receipt of a pin or other projecting member therein. The end portions 30a extend adjacent a bottom wall 28d through which openings 34a communicate with the aperture 34. Accordingly, pins such as those pins 18 shown in the header 12 of Fig. 1, may be introduced through the openings 34a for receipt and connection to the contact end portions 30a. It should be appreciated that while the contact end portions 30a are shown as socket-type, the end portions 30a may also be of the pin-type for external connection to an external socket (not shown).

The contact second end portions 30b extend laterally outwardly from the central housing portion 28a, each end portion 30b being supported by a respective lateral housing portion 28b and 28c in a plurality of individual recesses 36 formed in the upper portion of the housing 28. In the preferred arrangement, the contact second end portions 30b extend in a direction substantially orthogonal to the direction of the first end portions 30a. Formed in each of the contact second end portions 30b are two contact members 30c and 30d for connection to the leads of the IC, as will be described. In the configuration illustrated, contact members 30c and 30d are spaced laterally from each other, contact members 30d being more distal laterally from the central housing portion 28a than the contact members 30c. It should be understood that while each contact 30 includes two such contact members 30c, in practice, the invention is not limited thereto. In each of the housing lateral portions 28b and 28c, there are formed a plurality of openings 38 and 40, communicating individually with the recesses 36, and in registry, respectively, with the contact members 30c and 30d, the openings 38 and 40 extending through the housing portions 28b and 28c. Each of the contact members 30c and 30d is formed as a curved, cantilevered spring member, the distal unsupported end of which extends downwardly into a respective housing opening 38 or 40. As illustrated in enlarged detail in Fig. 5, the distal end of the contact members, for example 30d, are disposed in the opening 40 such that there is a spacing S1 between a wall 40a of opening 40 and the end of the contact member 30d. As such, the contact member 30d serves as a spring for biased engagement with a lead of an IC upon insertion into the socket 28 to form the socket assembly, as will be detailed. In addition, the gap S2 between the end of the contact member 30d and the opposed portion of the wall 40a of the opening 40 is preferably formed to a dimension less than that of an IC lead such that the gap S2 defines an interference opening for the lead which is resiliently expandable upon insertion of such lead.

In the socket assembly 14 as shown in Fig. 2, the packages 24 and 26 are attached to the socket 22. The lateral spacing S3 between a corresponding pair of the more interior contact members 30c is approximately equal to the lateral spacing between the leads 24a of package 24 while the lateral spacing S4 between the more exterior contact members 30d is approximately equal to the lateral spacing between the leads 26a of package 26. In actual practice, the spacing S3 may be about 7,62 mm (0.300 inch) while the spacing S4 may be about 15,24 mm (0.600 inch). Upon insertion of the leads 24a and 26a into the socket 22, the leads initially engage the respective contact members 30c and 30d and, under the influence of the springr bias, and the resiliently constructed opening as described with reference to Fig. 5, a wiping action occurs as the leads slide past the ends of the contact members. Upon further insertion, while the spacing S1 (Fig. 5) between the contact members and the housing wall of opening 40 contracts, the contact members preferably do not engage the walls of the opening 40 and, as such, the spring bias of the contact members is retained upon completion of the package lead insertion. The package leads, for example, leads 24a as depicted in Fig. 2, are preferably soldered to the contact members 30c to form a joint 42 by a suitable technique such as vapor-phase soldering. Such soldering is readily accomplished as the contact second end portions 30b are selectively tin-plated or otherwise suitably coated and as the electric packages are typically available with pre-tinned leads.

Having described the details of the present invention, the particular advantages may now be understood. The soldering of the IC package leads to the contacts of the socket provides a non-detachable, permanent securement therebetween that results in a gas-tight electrical connection of high reliability and capable of withstanding severe environmental conditions. In effect, the IC package has been converted itself to a socket (or header). Additionally, the IC leads are protected from mechanical abuse which facilitates handling, storage and shipping and also provides a suitable anti-static shield for the IC. The socket assembly 14 is readily disengageable with conductors of an external electric device, such as a printed circuit board, or, as shown in Fig. 1, with the pins 18 of a header 12. Detachable connection is facilitated by selectively providing a gold-plated surface on the contacts 30 at the first end portions 30a. Such plating, which is also in a disengageable connection preferably similarly disposed on the connectable portions of the header pins 18, provides for repeated disconnection and thereby ease of replacement and repair. In the connector module 10 shown in Fig. 1, the header 12 through pins 18 may be soldered to a PCB or other component and disengageable connection of the socket assembly 14 to such header 18 is readily made by use of the ejector mechanism 20 without need of additional tools.

In another advantage of the presently described invention, selectivity of package interconnection is provided which not only enhances use of "real estate" for package density considerations, but also provides flexibility in the use of various package designs. For example, as shown in Fig. 6, the provision of two pairs of differently spaced contact members (e.g., at openings 38 defining the first pair and at openings 40 defining the second pair) at the same longitudinal position, allows for the interconnection at such longitudinal position of two packages having different laterally spaced leads or of one package or the other. As depicted in Fig. 6, package 26 may be an EPROM having leads laterally spaced at 15,24 mm (0.600 inch) while package 24 may be another IC package having leads laterally spaced at 7,62 mm (0.300 inch). A resistor network 44 may similarly have spaced leads at 15,24 mm (0.600 inch). While in Fig. 6, the packages are longitudinally spaced from each other, such packages, where common electrical connection is desired, may also be superimposed relative to each other as shown in Fig. 1. In Fig. 1, package 26 may be a resistor network wherein one or more of its leads are electrically connected to the same contacts 30 to which the leads of an IC package 24 are connected. Accordingly, the provision of at least two contact members 30c and 30d in the second end portion 30b of each contact allows for selective positional securement of packages to the socket for common electrical connections and/or for accommodation of ICs having different lateral spacings of leads.

In yet another advantage, the socket 22 of the presently described invention converts the spacing of the electric packages to a different spacing that may be more suitable for interconnections to PCBs or the like. For example, as indicated hereinabove, the spacing S3 may be about 7,62 mm (0.300 inch) and the spacing S4 may be about 15,24 mm (0.600 inch). Both, or either, of these spacings are converted through the contacts 30 to a spacing S5 at which the socket assembly 14 is terminated. Spacing S5 may be about 2,54 mm (0.100 inch). As such, connections may be made to the pins 18 of a header which are arranged in a 2,54 mm (0.100 inch)×2,54 mm (0.100 inch) matrix.

Having described the preferred embodiment of the invention together with its attendant advantages herein, it should be appreciated that other various modifications may be made without departing from the contemplated scope of the invention. Accordingly, the particularly described preferred embodiment is intended to be illustrative and not limited thereto. The true scope of the invention is set forth in the following claims.

## Claims

1. An electrical socket for disengageable connection to conductors of an electric component (12) comprising:

an elongate insulative housing (28) for receiving an electric package (24, 26) having a plurality of conductive leads (24a, 26a) extending therefrom, said housing including a central portion (28a) having a plurality of apertures (34) extending in spaced disposition longitudinally along the housing central portion, said housing including two lateral portions (28b, 28c) extending transversely relative to the longitudinal axis of the central portion along said housing, two rows of openings (38, 40) extending longitudinally in each of said lateral portions, said rows of openings being laterally spaced from each other, said lateral portions having a plurality of laterally extending, longitudinally spaced recesses (36), each recess communicating with one opening of each row; and

a plurality of conductive electrical contacts (30) supported on said housing, each contact including a first end portion (30a) disposed in a respective one of said apertures for disengageable electrical engagement with a conductor of said electrical component and a second end portion (30b) having a projecting extent, each projecting extent lying in a respective recess in said housing lateral portions, there being on each projecting extent a pair of contact members (30c, 30d) in registry with a pair of said openings, one from each row, in said lateral portions, said contact members adapted for selective engagement with said leads of said electric package.

2. An electrical socket according to claim 1, wherein said projecting extent of each contact second end portion comprises a generally flat surface and wherein said contact members each comprise a spring member biased to urge against a lead of said electric package.

3. An electrical socket according to claim 2, wherein said spring members are each cantilevered and curved and project into the respective openings (38, 40) of said housing.

4. An electrical socket according to claim 3, wherein the unsupported distal ends of said spring members cooperate with an opposed spaced wall portion of the housing defining each opening to provide a resiliently expandable opening for receipt of one of said leads of the electric package therein.

5. An electrical socket according to any one of claims 1 to 4, wherein said first end portions contain material thereon different from material of said second end portions and suitable for disengagement with said conductors of said electric component.

6. An electrical socket according to claim 5, wherein said material is gold and is selectively disposed on said contact first end portions.

7. An electrical socket according to any one claims 1 to 6 wherein said recesses are electrically insulated from each other.

8. An electrical socket according to any one of claims 1 to 7 wherein said contact first end portions extend substantially orthogonally relative to said contact projecting extents.

9. An electrical socket according to claim 8, wherein said housing central portion depends from said housing lateral portions defining therewith a housing cross-section of generally T-shape, said central portion adapted for connection with a header device comprising said conductors.

10. An electrical socket for disengageable connection to conductors (18) of an electric component (12) comprising:

an elongate insulative housing (28) for receiving an electric package (24, 26) having a plurality of leads (24a, 26a) extending therefrom in two laterally spaced longitudinally extending rows, said housing being adapted to receive electric packages having leads of different lateral spacing;

a first plurality of contacts (30) supported by said housing and extending longitudinally thereon;

a second plurality of contacts (30) supported by said housing laterally spaced from said first plurality of contacts and extending in corresponding longitudinal position with the first plurality of contacts;

each of said contacts of said first and second pluralities having a first end portion (30a) for disengageable electrical connection to a conductor of said electric component;

each of said contacts of said first and second pluralities have a second end portion (30b) for non-detachable securement with a lead of one of said electric packages, each of said second end portions having at least first and second contact members (30c, 30d) laterally spaced from each other for selective securement with a lead of said electric package, the first contact members of a spaced corresponding pair of contacts defining a first lateral spacing and the second contact members of such spaced corresponding pair of contacts defining a second lateral spacing different from said first lateral spacing, said first and second lateral spacings providing selectivity for receipt of electric packages having leads of different lateral spacings, the first end portions of a spaced corresponding pair of contacts of said first and second pluralities defining a third lateral spacing that is less than both said first and second lateral spacings,

said housing including a central portion (28a) for supporting said contact first end portions and transversely spaced lateral portions (28b, 28c) for supporting respectively the second end portions of the first and second pluralities of contacts, said housing lateral portions each having an opening in registry with each said contact member for joint receipt therein of a portion of one of said contact members and a lead of said electric package.

11. An electrical socket according to claim 10, wherein said housing central portion has a plurality of apertures (34) therein within which said first end portions of said contacts of both said first and second pluralities respectively reside and wherein said housing central portion depends from said housing lateral portions defining therewith a housing cross section of generally T-shape.

**Patentansprüche**

1. Eine elektrische Fassung zur lösbaren Verbindung mit den Leitern eines elektrischen Bauteiles (12) mit:

einem langgestreckten isolierenden Gehäuse (28) zur Aufnahme einer elektrischen Baueinheit (24, 26) mit einer Vielzahl von von dieser ausgehenden leitenden Adern (24a, 26a), wobei das Gehäuse einen zentralen Abschnitt (28a) mit einer Vielzahl von in Längsrichtung entlang des zentralen Gehäuseabschnittes verlaufenden und unter Abstand angeordneten Öffnungen (34) aufweist, das Gehäuse zwei entlang des Gehäuses gegenüber der Längsachse des zentralen Abschnittes querverlaufende Seitenabschnitte (28b, 28c) aufweist, zwei Reihen von Öffnungen (38, 40) in Längsrichtung in jedem der Seitenabschnitte verlaufen, die Reihen der Öffnungen voneinander seitlich auseinanderliegen, die Seitenabschnitte eine Vielzahl von seitlich verlaufenden, in Längsrichtung einen Abstand aufweisenden Vertiefungen (36) aufweisen, wobei jede Vertiefung mit einer Öffnung jeder Reihe in Verbindung steht; und

einer Vielzahl von am Gehäuse abgestützten leitenden elektrischen Kontakten (30), wobei jeder Kontakt einen in einer entsprechenden der Öffnungen zur lösbaren elektrischen Anlage an einem Leiter des elektrischen Bauteiles angeordneten ersten Endabschnitt (30a) und einen zweiten Endabschnitt (30b) mit einem vorstehenden Bereich aufweist, jeder vorstehende Bereich in einer entsprechenden Vertiefung in den Seitenabschnitten des Gehäuses liegt und auf jedem vorstehenden Bereich ein Paar von Kontaktgliedern (30c, 30d) in Deckung mit einem Paar von Öffnungen, eine von jeder Reihe, in den Seitenbereichen liegen, und die Kontaktglieder zur selektiven Anlage an den Adern der elektrischen Baueinheit bestimmt sind.

2. Eine elektrische Fassung gemäß Anspruch 1, wobei der vorstehende Bereich des zweiten Endabschnittes jedes Kontaktes eine allgemein ebene Oberfläche ist und wobei die Kontaktglieder sämtlich aus einem Federglied bestehen, das so vorgespannt ist, daß es gegen eine Ader der elektrischen Baueinheit gedrückt wird.

3. Eine elektrische Fassung gemäß Anspruch 2, wobei die Federglieder sämtlich auskragen und gebogen sind und in die entsprechenden Öffnungen (38, 40) des Gehäuses hineinragen.

4. Eine elektrische Fassung gemäß Anspruch 3, wobei die nicht abgestützten, entfernt liegenden Enden der Federglieder mit einem gegenüberliegenden, in einem Abstand befindlichen Wandabschnitt des Gehäuses zusammenwirken, der jede Öffnung zur Bildung einer elastisch expandierbaren Öffnung zur Aufnahme einer der Adern der elektrischen Baueinheit umschließt.

5. Eine elektrische Fassung gemäß irgendeinem der Ansprüche 1 bis 4, wobei die ersten Endabschnitte auf sich Material enthalten, das vom Material der zweiten Endabschnitte verschieden ist und sich zum Lösen von den Leitern des elektrischen Bauteiles eignet.

6. Eine elektrische Fassung gemäß Anspruch 5, wobei das Material Gold und selektiv auf den ersten Endabschnitten der Kontakte angeordnet ist.

7. Eine elektrische Fassung gemäß irgendeinem der Ansprüche 1 bis 6, wobei die Vertiefungen elektrisch voneinander isoliert sind.

8. Eine elektrische Fassung gemäß irgendeinem der Ansprüche 1 bis 7, wobei die ersten Endabschnitte der Kontakte im wesentlichen orthogonal zu den vorstehenden Kontaktbereichen verlaufen.

9. Eine elektrische Fassung nach Anspruch 8, wobei der zentrale Abschnitt des Gehäuses von den Seitenabschnitten des Gehäuses unter Bildung eines Gehäusequerschnittes von allgemein T-Form mit diesem herabhängt und der zentrale Abschnitt zur Verbindung mit einer die Leiter darstellenden Kopfstückvorrichtung bestimmt ist.

10. Eine elektrische Fassung zur lösbaren Verbindung mit den Leitern (18) eines elektrischen Bauteiles (12) mit

einem langgestreckten isolierenden Gehäuse (28) zur Aufnahme einer elektrischen Baueinheit (24, 26) mit einer Vielzahl von von dieser ausgehenden Adern (24a, 26a) in zwei seitlich auseinanderliegenden und in Längsrichtung verlaufenden Reihen, wobei das Gehäuse zur Aufnahme von elektrischen Baueinheiten mit Adern mit unterschiedlichem seitlichen Abstand bestimmt ist;

einer ersten Vielzahl von durch das Gehäuse abgestützten und in Längsrichtung auf diesem verlaufenden Kontakten (30);

einer zweiten Vielzahl von durch das Gehäuse abgestützten und in einem seitlichen Abstand zu der ersten Vielzahl der Kontakte verlaufenden Kontakten (30), und die in einer der ersten Vielzahl der Kontakte entsprechenden Längsstellung verlaufen;

wobei jeder der Kontakte der ersten und der zweiten Vielzahl einen ersten Endabschnitt (30a) zur lösbaren elektrischen Verbindung mit einem Leiter des elektrischen Bauteiles aufweist;

wobei jeder der Kontakte der ersten und der zweiten Vielzahl einen zweiten Endabschnitt (30b) zur nichtlösbaren Anbringung an einer Ader einer der elektrischen Baueinheiten aufweist, jeder der zweiten Endabschnitte mindestens ein erstes und ein zweites Kontaktglied (30c, 30d) aufweist, die zur selektiven Anbringung an einer Ader der elektrischen Baueinheit einen Seitenabstand voneinander aufweisen, die ersten Kontaktglieder eines auseinanderliegenden entsprechenden Kontaktpaares einen ersten Seitenabstand bestimmen und die zweiten Kontaktglieder eines solchen auseinanderliegenden entsprechenden Kontaktpaares einen zweiten, vom ersten Seitenabstand unterschiedlichen Seitenabstand bestimmen, der erste und der zweite Seitenabstand eine Selektivität zur Aufnahme von elektrischen Baueinheiten mit Adern mit unterschiedlichen Seitenabständen ermöglichen, die ersten Endabschnitte eines auseinanderliegenden entsprechenden Kontaktpaares der ersten und der zweiten Vielzahl einen dritten Seitenabstand bestimmen, der unter sowohl dem ersten als auch dem zweiten Seitenabstand liegt,

wobei das Gehäuse einen zentralen Abschnitt (28a) zum Abstützen der ersten Endabschnitte der Kontakte und in Querrichtung auseinanderliegende Seitenabschnitte (28b, 28c) zum Abstützen der zweiten Endabschnitte der ersten und der zweiten Veilzahl der Kontakte aufweist, und die Seitenabschnitte des Gehäuses sämtlich eine mit jedem Kontaktglied in Deckung liegende Öffnung aufweisen zur gemeinsamen Aufnahme eines Abschnittes eines der Kontaktglieder und einer Ader der elektrischen Baueinheit.

11. Eine elektrische Fassung nach Anspruch 10, wobei der zentrale Abschnitt des Gehäuses eine Vielzahl von Öffnungen (34) in sich aufweist, in denen die ersten Endabschnitte der Kontakte von sowohl der ersten als auch der zweiten Vielzahl aufgenommen sind, und wobei der zentrale Abschnitt des Gehäuses von den Seitenabschnitten des Gehäuses herabhängt, die mit ihm einen Gehäuseabschnitt von allgemein T-Form bilden.

**Revendications**

1. Douille électrique pour la connexion amovible sur des conducteurs d'un composant électrique (12) comprenant:

un logement isolant allongé (28) destiné à recevoir un ensemble électrique (24, 26) comportant plusieurs fils conducteurs (24a, 26a) s'étendant à partir de celui-ci, le logement comprenant une portion centrale (28a) munie de plusieurs ouvertures (34) s'étendant en agencement espacé longitudinalement le long de la portion centrale du logement, le logement comprenant deux portions latérales (28b, 28c) s'étendant transversalement par rapport à l'axe longitudinal de la portion central le long du logement, deux rangées d'ouvertures (38, 40) s'étendant longitudinalement dans chacune des portions latérales, ces rangées d'ouvertures étant latéralement espacées l'une de l'autre, les portions latérales comportant plusieurs évidements s'étendant latéralement, espacés longitudinalement, chaque évidement communiquant avec une ouverture de chaque rangée; et

plusieurs contacts électriques conducteurs (30) supportés par le logement, chaque contact comprenant une première portion d'extrémité (30a) disposée dans une portion respective des ouvertures pour l'introduction électrique amovible d'un conducteur du composant électrique et une seconde portion d'extrémite (30b) présentant une extension en saillie, chaque extension en saillie se situant dans un évidement respectif de la portion latérale du logement, sur chaque extension en saillie, une paire d'éléments de contact (30c, 30d) étant prévue en coïncidence avec une paire d'ouvertures, une pour chaque rangée, dans les portions latérales, les éléments de contact aptes à l'engagement sélectif avec des fils de l'ensemble électrique.

2. Douille électrique selon la revendication 1, dans laquelle l'extension en saillie de chaque seconde portion d'extrémité de contact comprend une surface généralement plate et dans laquelle les éléments de contact comprennent chacun un élément de ressort repoussé élastiquement en contact avec un fil de l'ensemble électrique.

3. Douille électrique selon la revendication 2, dans laquelle les éléments de ressort sont chacun en porte-à-faux et recourbés et font saillie dans les ouvertures respectives (38, 40) du logement.

4. Douille électrique selon la revendication 3, dans laquelle les extrémités distales non supportées des éléments de ressort coopérent avec une portion de paroi espacée opposée du logement définissant chaque ouverture pour fournir une ouverture dilatable élastiquement pour recevoir un des conducteurs de l'ensemble électrique.

5. Douille électrique selon l'une quelconque des revendications 1 à 4, dans laquelle les premières portions d'extrémité contiennent un matériau différent du matériau des secondes portions d'extrémité et convenant au désengagement par rapport au conducteur du composant électrique.

6. Douille électrique selon la revendication 5, dans laquelle le matériau est de l'or et est disposé selectivement sur les premières portions d'extrémité de contact.

7. Douille électrique selon l'une quelconque des revendications 1 à 6, dans laquelle les évidements sont isolés électriquement l'un par rapport à l'autre.

8. Douille électrique selon l'une quelconque des revendications 1 à 7, dans laquelle les premières portions d'extrémité de contact s'étendent sensiblement de façon orthogonale par rapport aux extensions de contact faisant saillie.

9. Douille électrique selon la revendication 8, dans laquelle la portion centrale de logement pend à partir des portions latérales de logement définissant avec celle-ci une section transversale de logement de configuration généralement en T, la portion centrale étant apte à la connexion avec un dispositif de branchement comprenant les conducteurs.

10. Douille électrique pour la connexion amovible avec des conducteurs (18) d'un composant électrique (12) comprenant:

un logement isolant allongé (28) destiné à recevoir un ensemble électrique (24, 26) comportant plusieurs conducteurs (24a, 26a) s'étendant à partir de celui-ci dans deux rangées espacées latéralement et s'étendant longitudinalement, le logement étant apte à recevoir des ensembles électriques comportant des fils d'espacement latéral différents;

un premier ensemble de contacts (30) supportés par le logement et s'étendant longitudinalement sur celui-ci;

un second ensemble de contact (30) supporté par le logement espacé latéralement à partir du premier ensemble de contacts s'étendant en position longitudinale correspondant avec le premier ensemble de contacts;

chacun des contacts des premier et second ensembles comportant une première portion d'extrémité (30a) pour la connexion électrique amovible sur un conducteur du composant électrique;

chacun des contacts des premier et second ensembles comporte une seconde portion d'extrémité (30b) pour la fixation non amovible avec un conducteur de l'un des ensembles électriques, chacune des secondes portions d'extrémité ayant au moins des premier et second éléments de contact (30c, 30d) espacés latéralement l'un par rapport à l'autre pour la fixation sélective avec un fil de l'ensemble électrique, les premiers éléments de contact d'une paire correspondante espacée de contacts définissant un premier espacement latéral et les seconds éléments de contact de cette paire correspondante espacée de contact définissant un second espacement latéral différent du premier, ces premiers et seconds espacements latéraux assurant la sélectivité pour la réception des ensembles électriques comportant des fils d'espacement latéraux différents, les premières portions d'extrémité d'une paire correspondante espacée de contacts des premier et second ensembles définissant un troisième espacement latéral qui est inférieur à la fois aux premier et second espacements latéraux;

le logement comprenant une portion centrale (28a) destinée à supporter les premières portions d'extrémité de contact et les portions latérales espacées transversalement (28b, 28c) destinées à supporter respectivement les secondes portions d'extrémité des premier et second ensembles de contact, les portions latérales de logement ayant chacune une ouverture en coïncidence avec chacun des éléments de contact pour la réception commune dans celui-ci d'une portion de l'un des éléments de contact et un fil de l'ensemble électrique.

11. Douille électrique selon la revendication 10, dans laquelle la portion centrale de logement comporte un ensemble d'ouvertures (34), dans laquelle les premières portions d'extrémité des contacts à la fois des premier et second ensembles respectivement sont logés et dans lequel la portion centrale de logement pend à partir des portions latérales de logement définissant avec celle-ci une section transversale de logement de configuration généralement en forme de T.

FIG. 1

EP 0 137 656 B1

FIG. 2

FIG. 6

2

FIG. 3

FIG. 4

FIG. 5